# EUROPEAN PATENT APPLICATION

(11) **EP 2 362 313 A1**
(43) Date of publication of application: **31.08.2011**
(21) Application number: 11250096.2
(22) Date of filing: 28.01.2011
(51) Int. Cl.: G06F 11/263, G01R 31/317

(54) **Apparatus and method for generating a waveform test signal having crest factor emulation of random jitter**

(30) Priority: 02.02.2010 IN MU02552010
(71) Applicant: Tektronix, Inc., Beaverton, Oregon 97077-0001 (US)
(72) Inventor: Stephens, Ransom W., Petaluma, California 94952 (US); Karapattu, Muralidharan, Bangalore-560 101 Karnataka (IN); Desai, Sampathkumar R., Bangalore - 560076 Kamataka (IN); Calvin, John C., Portland, Oregon 97229 (US)
(74) Representative: Brinck, David John Borchardt

(57) **Abstract**

A signal generating device has a display and a central processing unit for setting parameters for a serial data pattern and parameters for deterministic and random jitter impairments, and a displacement crest factor emulation impairment to be applied to the serial data pattern. A waveform record file is generated using the serial data pattern parameters, the impairment parameters for the deterministic jitter and random jitter, and the displacement crest factor emulation impairment. The displacement crest factor emulation impairment is selectively positioned in the impaired serial data pattern. A waveform generation circuit receives the waveform record file and generates an impaired serial data pattern analog output signal based on the serial data pattern, deterministic and random jitter impairments, and the displacement crest factor emulation impairment with the displacement crest factor emulation impairment being selectively positioned in the impaired serial data pattern analog output signal.

## Description

### Background of the Invention

In a high speed serial system (HHS), one performance measurement of the receiver is the bit error ratio or rate. The bit error ratio performance of the receiver will depend on the total jitter in the received signal which is a combination of both deterministic jitter and random jitter. Jitter has significant effect on the bit error ratio in HSS systems exceeding gigabit per second rates. Generally, a transmitter in a HHS system outputs a differential signal that is coupled via cables and a backplane to the receiver. The differential signal is coupled to an equalizer that includes a comparator that converts the differential signal to a single-ended signal. The single-ended signal is coupled to a clock recovery circuit that fabricates a data-rate clock signal based on the timing of the incoming waveform logic transitions. The resulting clock includes low frequency jitter that is on the data. The recovered clock sets the timing of a decision circuit that serves as a high pass jitter filter.

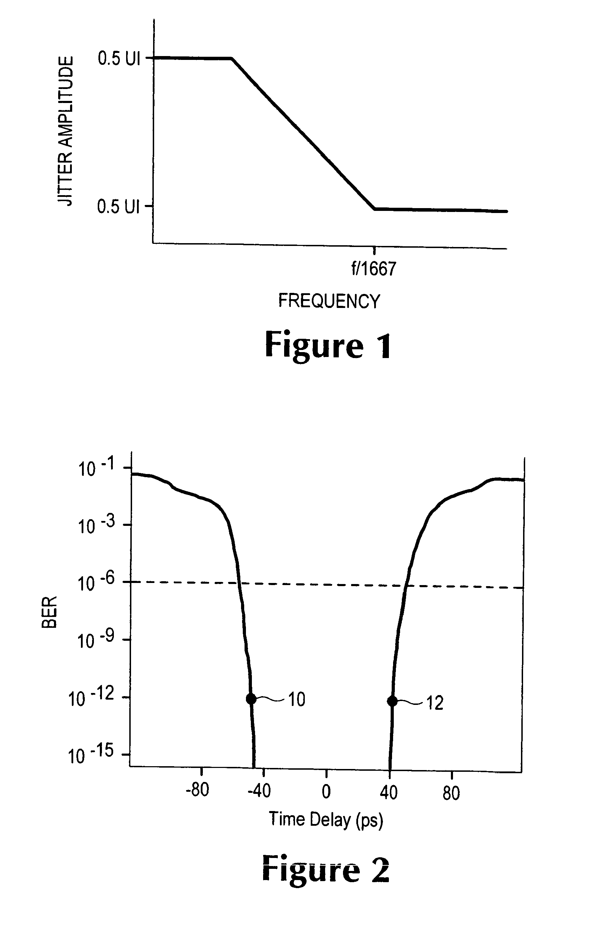

Deterministic jitter has correlated components, such as Intersymbol Interference (ISI), duty cycle distortion (DCD) and the like, or uncorrelated components, such as sinusoidal jitter, some forms of crosstalk, and the like. The deterministic jitter of the signal is easily characterized by a peak to peak value. Intersymbol interference causes both jitter and voltage noise which causes eye closure in both the vertical and horizontal directions. Intersymbol interference occurs at rational fractions of the data rate and with amplitudes that depend on the loss characteristics of the transmission path. Several standards (e.g. SATA, SAS, DisplayPort, RapidlO, USB 3.0) require that the sinusoidal jitter be applied according to a template as shown in Figure 1. To probe the clock recovery frequency response, multi Unit Interval (Ul) amplitude sinusoidal jitter is applied below the clock recovery bandwidth and fractional Unit Intervals above.

On the other hand, random jitter of the signal can only be characterized by its statistical properties, like its Probability Density Function (PDF), mean and standard deviation. A designer uses the standard deviation (sigma) of the random jitter and combines it with deterministic jitter to obtain the total jitter of the signal to verify the system jitter budget. The bit error ratio as a function of a sampling point location on the PDF curve of random jitter can be expressed as the number of sigma (No) from mean (where N is a real number). Here the bit error ratio is considered as an approximate estimate of the bit error probability. This method can evolve a theoretical model to estimate jitter budget for a given bit error ratio. But to experimentally verify this requires the generation of a signal with given jitter components and evaluate the bit error ratio. Typically for a Gaussian PDF, a bit error ratio of 10⁻¹² will occur at 14 times sigma from the mean. Here the mean is worst case deterministic jitter value. This happens at the tail end of PDF with a very low probability. Hence using real world random jitter, this event will occur after a very long time. Thus to practically measure expected bit error ratio one has to wait for a long time.

Figure 2 is a cumulative distribution function of a jitter probability density function (bathtub plot) for a bit error ratio (BER) as a function of sampling-point time-delay position for a 6 Gb/s Serial ATA Gen-3 stress signal. The structure of the bathtub curve is caused by a displacement inward at high probability dictated by the deterministic jitter followed by long smooth tails caused by the random jitter. The eye-opening at different bit error ratios is given by the distance between the two curves and the total jitter (TJ) is given by the nominal bit period minus the eye opening at the bit error ratio.

The most important tests are in the high probability region above the dashed line of Figure 2 where the high probability low amplitude random jitter and bounded high probability jitter (i.e. deterministic jitter) dominate. The effect of deterministic jitter at high probabilities, bit error ratio greater than 10⁻³ in Figure 2 and, generally, for bit error ratios greater than 10^{-5,} causes most of the structure in the curves. For example, at the time-delay just larger than sinusoidal jitter amplitude, the bit error ratio should experience a rapid decline. Similar abrupt drops in the bit error ratio should be expected at the time-delays corresponding to the largest intersymbol interference variations. All of this structure occurs in the region above the dashed line. At lower probabilities, below the dashed line (bit error rate of less than 10⁻⁶) the unbounded low probability random jitter fluctuations give the curves their predictable unwavering smooth decay.

The distance between the two points 10 and 12 at the bit error ratio equal to 10⁻² in Figure 2 gives the maximum compliant receiver sensitivity. That is, a perfect receiver would have a jitter margin given by the distance between the two points 10 and 12 and operate with a bit error ratio of much less than 10⁻¹². If the setup and hold time in the decision circuit of the receiver is exactly the distance between the points 10 and 12, then the receiver has no margin, and would operate at a bit error ratio equal to 10⁻¹². If the setup and hold time is larger than the distance between to two points 10 and 12, then the receiver would operate with a bit error ratio that is greater than 10⁻¹², and fail the test.

Receiver compliance testing requires a signal generator capable of generating a signal with a crest factor sufficient to probe the bit error ratio requirement of the technology standard; a bit error ratio of 10⁻¹² requires a 14σ spread in the random jitter distribution, equivalent to a crest factor of 7 or about 8.5 dB.

Compliance requires that bit error ratio of less than 10⁻¹² be verified on at least two frequency-amplitude points of the sinusoidal jitter template with appropriate confidence, usually a 95% confidence level upper limit is satisfactory. Ignoring the fact that certain logic transitions in the compliance pattern exert a greater stress than others and no errors occur, 3x10¹² bits samples are needed for each point in the sinusoidal jitter template.

Random tests require substantial statistical samples of data to attain accurate confidence levels. To obtain a sufficient statistical sample to test the receiver all the way down the bathtub curve to 10⁻¹² requires many minutes; for a bathtub curve to 10⁻¹⁵ requires many days; and for bathtub curves to 10⁻¹⁸ (years) required years.

The successful operation of links at multi Gb/s data rates requires either an extraordinarily high quality transmission path or a receiver architecture capable of tolerating crosstalk, jitter, and amplitude noise. Over the last decade communications and computer standards such as PCI Express, Serial ATA and 10 GbE increasingly require that receivers include components that enable them to tolerate impairments. Clock data recovery and equalization circuits allow receivers to accommodate signals that may be so distorted that they are unrecognizable as digital signals. A "receiver tolerance test" probes the ability of a receiver to work with a degraded input signal. The idea is to subject the receiver to a well defined worst case signal and require that it operate at a specified Bit Error Ratio (BER), usually 10⁻¹² or lower.

### Summary of the Invention

The present invention is a signal generating device and a method of generating a waveform test signal having crest factor emulation of random jitter. The signal generating device has a display, central processing unit and a waveform generation circuit. The central processing unit generates a user interface on the display for setting parameters for a serial data pattern and parameters for deterministic and random jitter impairments and at least one displacement crest factor emulation impairment to be applied to the serial data pattern. A waveform record file is generated using the serial data pattern parameters, the serial data pattern impairment parameters for the deterministic and random jitter and the displacement crest factor emulation impairment. The displacement crest factor emulation impairment is selectively positioned in the impaired serial data pattern. A waveform generation circuit receives the waveform record file and generates an impaired serial data pattern analog output signal based on the serial data pattern parameters, the parameters for deterministic and random jitter impairments and at least one displacement crest factor emulation impairment with the displacement crest factor emulation impairment being selectively positioned in the impaired serial data pattern analog output signal.

The parameter for the displacement crest factor emulation impairment is a low probability, large amplitude jitter sigma (σ) value greater than four sigma (σ) of the random jitter impairment. A plurality of parameters for displacement crest factor emulation impairments may be applied to the serial data pattern with each parameter for displacement crest factor emulation impairment having a selectable low probability, large amplitude jitter sigma (σ) value. Each of the displacement crest factor emulation impairment parameters of the plurality of displacement crest factor emulation impairment parameters may be selectively positioned in the impaired serial data pattern with increasing selectable low probability, large amplitude jitter sigma (σ) values for each of the plurality of displacement crest factor emulation impairment parameters being positioned at increasingly longer durations of the impaired serial data pattern.

In an embodiment, the parameters for the deterministic jitter impairments are selected from a group of parameters for intersymbol interference impairments, duty cycle distortion impairments, sinusoidal jitter impairments, spread spectrum clock impairments, and crosstalk impairments.
The serial data pattern corresponds to a serial data standard having templates wherein the frequencies of the sinusoidal jitter impairments correspond to the frequencies of serial data pattern template.

In an embodiment, the random jitter impairments are pseudorandom jitter impairments that are applied to every transition of the serial data pattern except for a transition having median deterministic jitter impairments. The transition having median deterministic jitter impairments has a median level intersymbol interference and one-half sinusoidal amplitude.

A method of generating a waveform test signal having crest factor emulation of random jitter has the steps of generating a serial data pattern, applying deterministic jitter impairments to the serial data pattern, applying random jitter impairments to selected portions of the waveform test signal, and applying at least one displacement crest factor emulation impairment at a location in the serial data pattern where the random jitter impairments are absent. A waveform test signal is generated from the serial data pattern having deterministic jitter impairments, random jitter impairments, and the displacement crest factor emulation impairment. The generation of the waveform test signal has the additional step of generating a waveform record file having the serial data pattern representing the waveform test signal with deterministic jitter impairments, random jitter impairments, and the displacement crest factor emulation impairment

The deterministic jitter impairments applying step has the further step of generating deterministic jitter impairments selected from a group of parameters for intersymbol interference impairments, duty cycle distortion impairments, sinusoidal jitter impairments, spread spectrum clock impairments, and crosstalk impairments. The generating of intersymbol interference impairments may include the step of generating the intersymbol interference impairments from S-parameter data. The S-parameter data characterizes the frequency response of an interconnect system between a serial communication system transmitter and receiver. The applying deterministic jitter impairments step applying may also include the step of generating sinusoidal jitter impairments. The generating of sinusoidal jitter impairments step has the step of setting sinusoidal jitter amplitude and frequency values as a function of a serial communication system standard template. The random jitter impairments applying step has the further step of generating pseudorandom jitter impairments.

The displacement crest factor emulation impairment has a large amplitude, low probability jitter value having a value of greater than 4σ of the random jitter impairment distribution. The step of applying at least one displacement crest factor emulation impairment has the additional step of generating a displacement crest factor emulation impairment at a transition location in the serial data pattern having a median level intersymbol interference and one-half sinusoidal amplitude. The step of applying at least one displacement crest factor emulation impairment has a further step of applying a plurality of displacement crest factor emulation impairments with each displacement crest factor emulation impairment having a selectable low probability, large amplitude sigma (σ) jitter value. The applying of the plurality of displacement crest factor emulation impairments includes the step of increasing the low probability, large amplitude sigma (σ) jitter values for each of the plurality of displacement crest factor emulation impairments and positioning each of the increasing low probability, large amplitude sigma (σ) jitter values of the plurality of displacement crest factor emulation impairments at increasingly longer durations of the impaired serial data pattern.

The objects, advantages and other novel features of the present invention are apparent from the following detailed description when read in conjunction with the appended claims and attached drawings.

### Brief Description of the Drawings

Figure 1 is a template for applying sinusoidal jitter to a test signal set by various high speed serial system standards.

Figure 2 is a cumulative distribution function of a jitter probability density function (bathtub plot) for a bit error ratio (BER) as a function of sampling-point time-delay position for a 6 Gb/s Serial ATA Gen-3 stress signal.

Figure 3 is a Gaussian distribution of 10⁶ instances with a single low probability 10⁻¹² outlier for describing a signal generator for generating a waveform test signal having crest factor emulation of random jitter according to the present invention.

Figures 4a ― 4c depict a representative SATA Gen 3 waveform illustrating a 10⁻¹² probability outlier in a signal generator for generating a waveform test signal having crest factor emulation of random jitter according to the present invention.

Figure 5 is a flow chart illustrating the steps in generating a synthesized binary test pattern in a signal generator for generating a waveform test signal having crest factor emulation of random jitter according to the present invention.

Figure 6 is a front view of a signal generator for generating a waveform test signal having crest factor emulation of random jitter according to the present invention.

Figure 7 is a representative block diagram of a signal generator according to the present invention.

Figure 8 is an initial user interface for generating a waveform test signal having crest factor emulation of random jitter according to the present invention.

Figure 9 is representation of a base pattern pop-up window in the user interface for generating a waveform test signal having crest factor emulation of random jitter according to the present invention.

Figure 10 is a representation of a Transmitter pop-up window in the user interface for generating a waveform test signal having crest factor emulation of random jitter according to the present invention.

Figure 11 is a representation of a channel/cable pop-window in the user interface for providing ISI scaling from a Touchstone files for generating a waveform test signal having crest factor emulation of random jitter according to the present invention.

Figure 12 is a representation of a compile setting pop-up window in the user interface for generating a waveform test signal having crest factor emulation of random jitter according to the present invention.

Figure 13 is a representation of a sequencer user interface of the signal generator 10 for setting sequences of stored waveform record files for generating a waveform test signal having crest factor emulation of random jitter according to the present invention.

Figure 14 illustrates total jitter composed of periodic jitter and a crest factor emulation of random jitter in a unit interval of a waveform test signal.

Figure 15a illustrates sine jitter in a waveform test signal having crest factor emulation of random jitter according to the present invention.

Figure 15b illustrates the random jitter with a Crest Factor value in a waveform test signal having crest factor emulation of random jitter according to the present invention.

Figure 15c illustrates the total jitter being the combination of the sine jitter and the random jitter with a Crest Factor value in a waveform test signal having crest factor emulation of random jitter according to the present invention.

Figure 16 is a representation of the sequencer user interface of the signal generator for implementing an alternative embodiment of setting sequences of stored waveform record files for generating a waveform test signal having multiple instances of crest factor emulation of random jitter according to the present invention.

### Detailed Description of the Invention

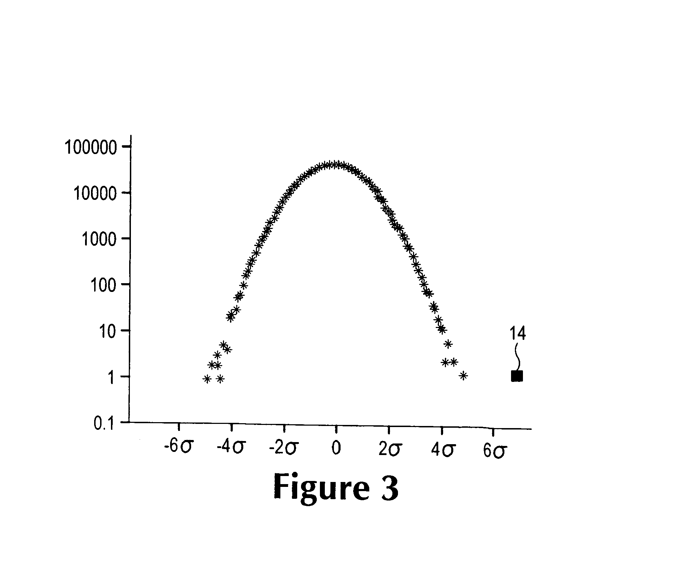

The crest factor emulation of the present invention uses a deep memory signal generator, such as a AWG7102 manufactured and sold by Tektronix, Inc. Beaverton, Oregon, to synthesize a complete stressed waveform that includes deterministic jitter, such as sinusoidal jitter, intersymbol interference, spread spectrum clock, duty cycle distortion crosstalk and the like, and random jitter. It should be noted that in the test lab a truly random signal cannot be reproduced or controlled. The crest factor emulation of the present invention applies pseudorandom noise as the requisite random jitter in a calculated fashion. The essence of the crest factor emulation is to synthesize random jitter and introduce large amplitude, low probability instances of the bit error ratio equal to 10⁻¹² where the instances are most useful. Figure 3 shows a distribution of random jitter instances that follow a Gaussian distribution including a single 10⁻¹² probability outlier jitter instance indicated by the square 14 at 7σ. Introduction of the low probability, large amplitude instance of jitter has no effect on the frequency spectrum.

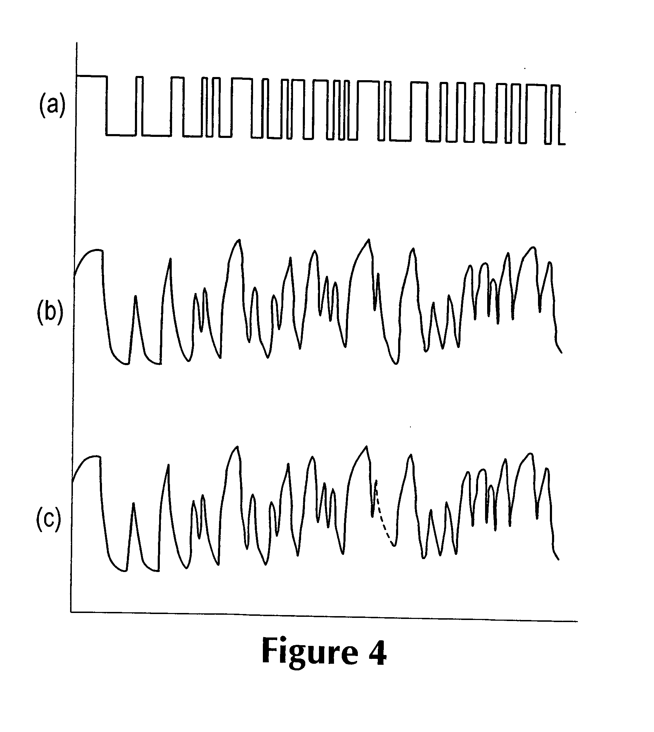

Figures 4a depicts a representative SATA Gen 3 waveform pattern generated by the signal generator while Figure 4b depicts the same waveform pattern with various impairments, such as sinusoidal jitter, intersymbol interference, random jitter and the like. Figure 4c depicts the same waveform pattern with the various impairments but with an instance of 7σ random jitter as shown by the dashed line in the wave form. In the preferred embodiment, the 7σ outlier is applied to a transition that experiences both a median level intersymbol interference and half the sinusoidal amplitude. A median level of intersymbol interference and half amplitude sinusoidal jitter is the most probable instance of deterministic jitter. The placement of the 7σ random jitter instance is by example only, and the 7σ random jitter instance may be placed anywhere in the impaired waveform pattern that would be compliant with high speed serial system standards.

The use of crest factor emulation of the present invention has a number of advantages over the prior art systems and methods for measuring the bit error ratio to 10⁻¹² and below. There are three differences between tests with the crest factor emulation of the present invention and tests with a hardware noise source of the prior art: test time, access to low probabilities, and repeatability. A user needs to control the test signal applied to the receiver under test. Without control , tests cannot be reproduced for verification and systematic uncertainty destroys precision. If a receiver under test can tolerate a carefully controlled worst case test signal with crest factor emulation, then the bit error ratio of the receiver is assured to be less than 10⁻¹² in a test that takes a few seconds instead of minutes as in previous prior art systems. In addition, the same test can be performed to test tolerances down to 10⁻¹⁵ or 10⁻¹⁸ without an increase in time.

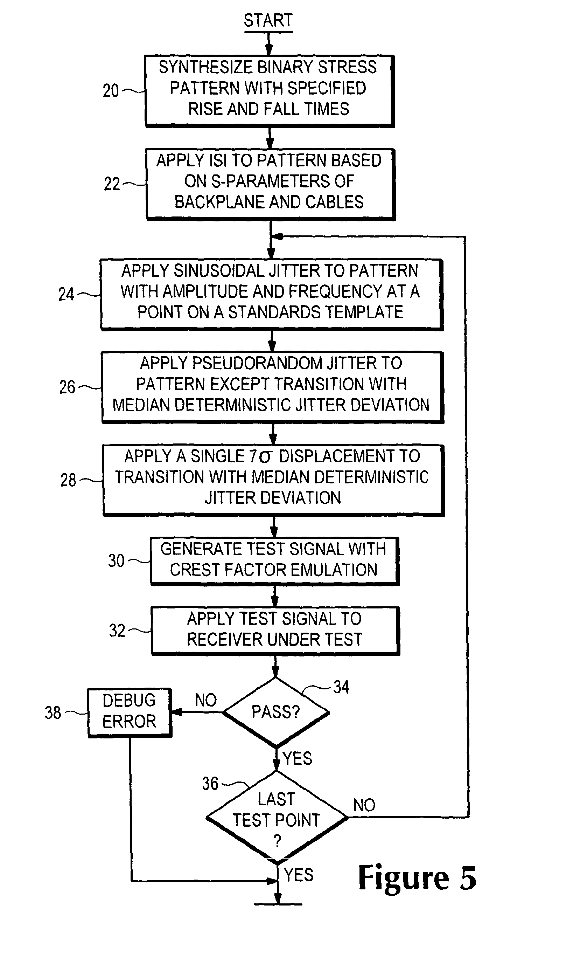

Figure 5 is a flow chart for generating a synthesized waveform pattern with crest factor emulation using a signal generator and performing compliant stressed receiver tolerance testing. At step 20, a binary test pattern is synthesized using the signal generator having specified rise and fall times. The binary test pattern is stressed by adding impairments to the pattern. Intersymbol interference impairments are applied to the synthesized test pattern according to S-parameters that correspond to the backplane and cable deterministic jitter requirements for the configuration in which the receiver function as shown in step 22. Sinusoidal jitter impairments having amplitude and frequency prescribed by a standards template, such as shown in Figure 1, are applied to the synthesized test pattern in step 24. A pseudorandom Gaussian random jitter impairment is generated and applied to every transition in the synthesized signal except for the one with median deterministic jitter (i.e. the edge with median intersymbol interference and one-half amplitude sinusoidal jitter) at step 26. The impaired synthesized test signal is repeated enough times that the sinusoidal swing in represented on every unique bit trajectory. A single 7σ displacement of the transition with median deterministic jitter deviation is applied to the synthesized test pattern at step 28. The impaired synthesized test signal is generated at step 30 and applied to the receiver under test at step 32. If the receiver under test passes as depicted at step 34, the frequency of the sinusoidal jitter is modified to coincide with another point on the template and another impaired synthesized test signal is generated and applied to the receiver under test. Three different impaired synthesized test signals are generated, one for the sinusoidal jitter at a frequency within the clock recovery bandwidth (i.e. below the roll off), one for the sinusoidal frequency at the end of the roll off, and one at a frequency above the clock recovery bandwidth. At the completion of each impaired synthesized test signal, a determination is made as to whether the last frequency test point is reached as depicted at step 36. If the last frequency test point has not been reached, then the compliant stressed receiver tolerance test resets to a different frequency point on the template and generates a new impaired synthesized test signal. If the receiver under test fails one of the generated impaired synthesized test signals, the errored bit(s) are determined and debugged as depicted in step 38.

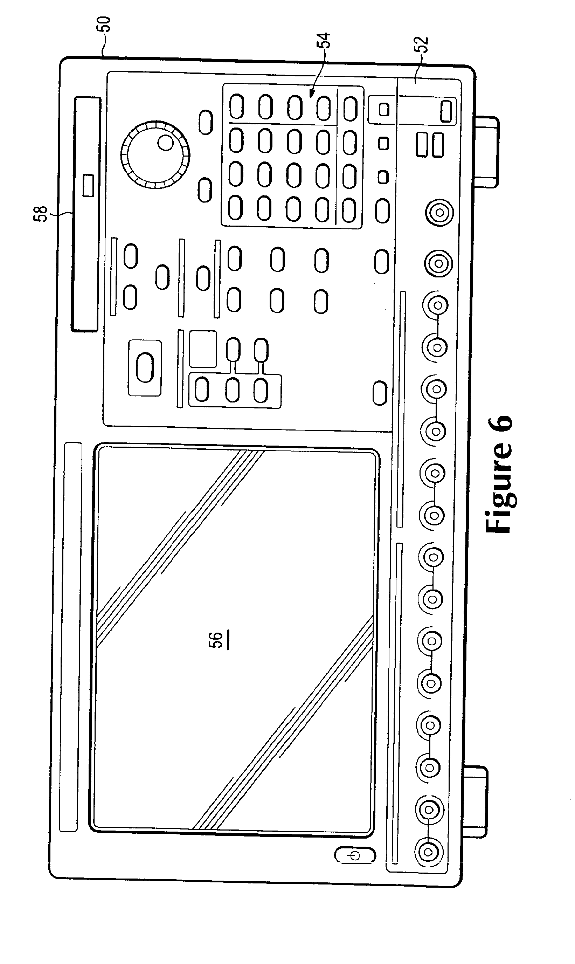

Referring to Figure 6, there is shown a signal generator 50, such as the AWG7102 manufactured and sold by Tektronix, Inc. Beaverton, Oregon for implementing the crest factor emulation according to the present invention. The signal generator 50 has a front panel 52 with controls 54, such as buttons and knobs or the like, and a display device 56, such as a liquid crystal display, cathode ray tube or the like. The signal generator 50 also has a CD or DVD/CD drive 58 for storing waveform data, executable programs and the like. User defined signals are generated and output by the signal generator 50 using the front panel controls in conjunction with a user interface displayed on the display device 56.

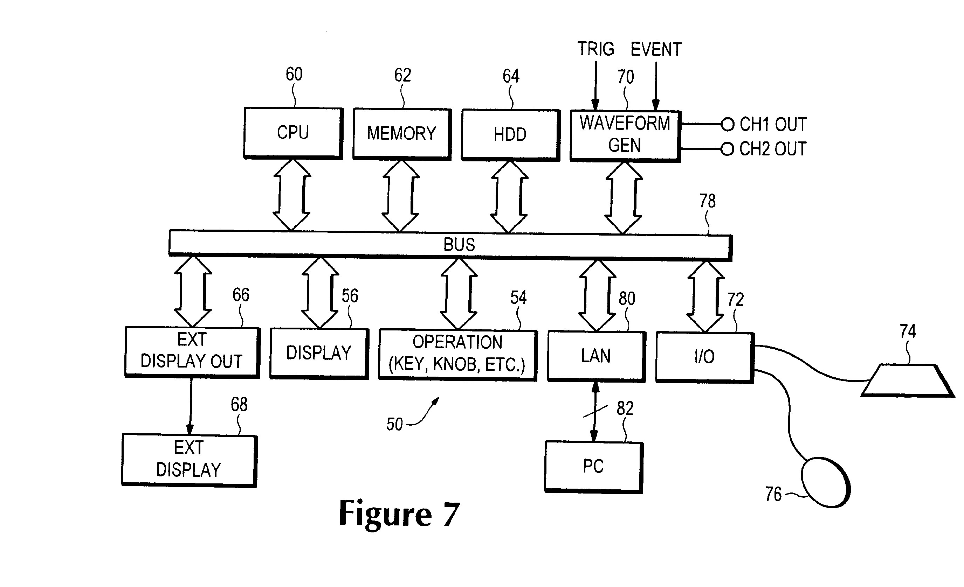

Referring to Figure 7, there is shown a representative block diagram of the AWG7102 signal generator 50 for generating a waveform test signal having crest factor emulation of random jitter. The signal generator 50 has a central processing unit (CPU) 60 that controls the operation of the instrument according to programs stored on electronic media, such as a Compact Disc (CD). A memory 62, such as RAM memory, is used for a work area for the CPU 60 to read programs from storage device 64, such as a hard disk drive. A user can set up the signal generator 50 to generate an output waveform test signal via the buttons, knobs and the like 54 on the front panel 52 of the instrument. The display device 56 may display a user interface for setting various parameters for the output waveform test signal and visualizing an output signal as a function of the parameter settings. An external display output circuit 66 provides a video output which may be connected to an external display 68 for providing a larger display area in addition to the built-in display 56 of the signal generator. A waveform generation circuit 70 generates the output waveform test signal based on user defined parameters. In this example, the waveform generation circuit 70 has a trigger input and an event input and two channel outputs. An input/output port 72 is used for connecting an external keyboard 74, a pointing device, such as a mouse 76, and the like to the signal generator. The external keyboard 74 and/or mouse 76 may be included as part of the front panel controls 54 of the signal generator 50 for setting parameters. The blocks are coupled together via a signal and data bus 78. The bus 78 of the signal generator may have a local Area Network (LAN) interface 80 for connecting the signal generator to an external controller, such as a personal computer (PC) 82 or other testing instruments. The LAN interface 80 allows the user interface to operate on the PC 82 and pass output signal data to the signal generator 50 and also enables the PC 82 to control the signal generator 50 over a network. Alternatively, a General Purpose Interface Bus (GPIB) interface may be used for the LAN interface 80.

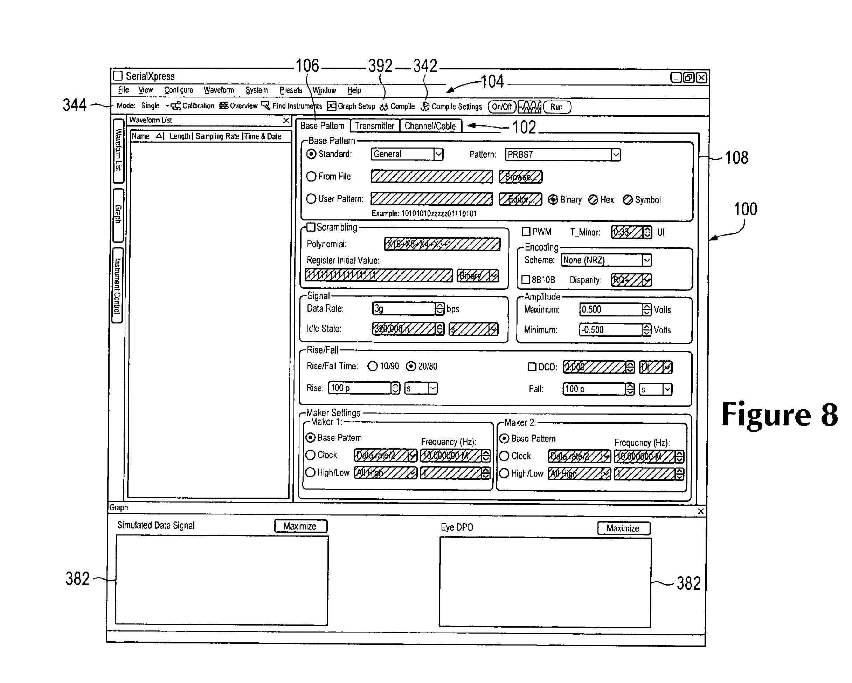

Referring to Figure 8, there is shown an initial user interface 100 for setting parameters to produce a waveform test signal having crest factor emulation of random jitter on serial data patterns. The initial user interface 100 and subsequent user interfaces operate under program control of the CPU 60 with the user interface programs stored on the storage device 64. The user interfaces may be displayed on the display device 56 or on the external display 68. Alternately, the user interface programs may be stored and accessed by the PC 82 with the PC 82 processing the parameters and generating an output file that is coupled to the signal generator 50. The programs controlling the various interfaces on the signal generator 50 may be accessed via an icon on the display device 56 or by clicking on a start tab and clicking the appropriate program from a list of programs stored in the signal generator 50. The initial interface 100 includes a number of pop-up windows that are activated by clicking on various tabs 102 or buttons 104 in the initial user interface 100. The initial user interface 100 has a BASE PATTERN tab 106 that activates a BASE PATTERN pop-up window 108. The BASE PATTERN pop-up window 108 is automatically activated with the initial user interface 100.

The initial user interface and associated pop-up windows allow a user to set serial data pattern parameters as well as impairment parameters that may be applied to the signal data pattern. The impairment parameters include deterministic jitter impairment and random jitter impairments. The deterministic jitter impairments may include intersymbol interference impairments, duty cycle distortion impairments, sinusoidal jitter impairments, spread spectrum clock impairments, and crosstalk impairments. The random jitter impairments may include multiple types of random jitter with each type having a different magnitude and frequency range. In a particular embodiment of the present in invention, the crest factor emulation impairment is applied to a single type of random jitter.

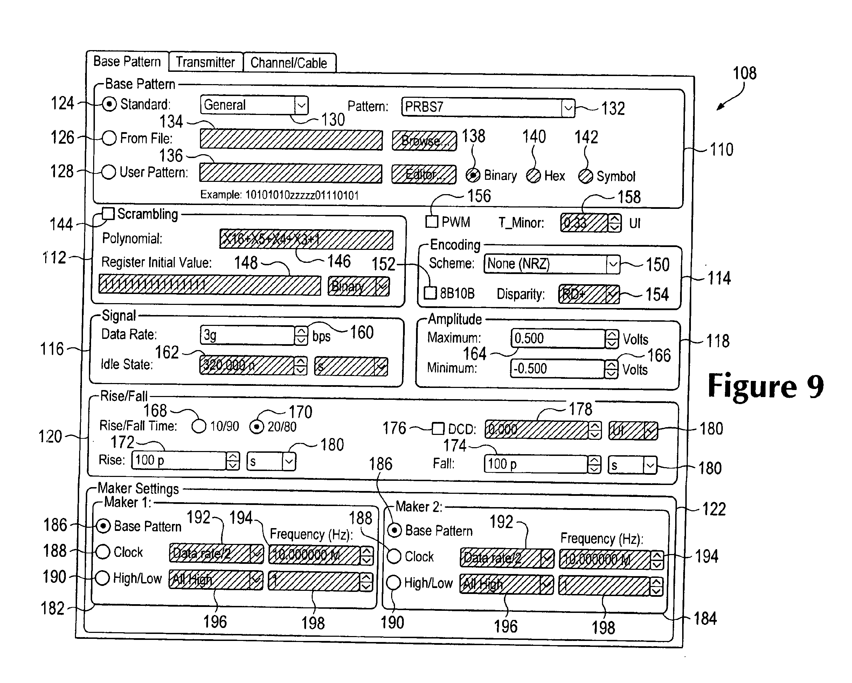

Figure 9 is a more detailed representation of the BASE PATTERN pop-up window 108 showing seven defined regions of the BASE PATTERN pop-up window 108: BASE PATTERN 110, SCRAMMBLING 112, ENCODING 114, SIGNAL 116, AMPLITUDE 118, RISE/FALL 120, and MARKER SETTING 122. The BASE PATTERN region 110 has buttons 124, 126 and 128 that allows a user to select a serial data pattern on which crosstalk emulation is generated. Clicking on the STANDARD button 124 activates a STANDARD box 130 and a PATTERN box 132. Click on the STANDARD box 130 allows the user to select from a number of serial data standards requiring compliance testing. Clicking on the PATTERN box 132 after selecting a particular serial data standard displays various waveform patterns defined by the selected serial data standard, such as PRBS7. Clicking on the FROM FILE button 126 highlights a FILE FIELD box 134 in which a user can enter a previously stored data file. Clicking on the USER PATTERN button 128 highlights a PATTERN FIELD Box 136 in which a user may enter a serial data pattern. The pattern may be entered as "0" and "1" binary data, hexadecimal data or symbol data by clicking on appropriate BINARY, HEX, or SYMBOL buttons 138, 140, 142. The diagonally shaded boxes and buttons indicate boxes and buttons that are not active.

Clicking on SCRAMBLING box 144 activates the SCRAMBLING region 112. The SCRAMBLING region 112 has a POLYNOMIAL box 146 in which the user may enter a scrambling polynomial for scrambling the selected serial data pattern. A REGISTER INITIAL VALUE FIELD 148 allows the user to set the initial state of the scrambling register in binary or hexadecimal and the length of the register. The register length is equal to the degrees of the polynomial. The ENCODING region 114 has an ENCODING SCHEME box 150 that allows the user to set the type of coding scheme for the serial data pattern. A user may select from NRZ, NRZI or 4-PAM. Clicking on the 8B10B box 152 activates an algorithm for the mapping of 8-bit symbols to 10-bit symbols to achieve DC-balance and bounded disparity. Clicking on the DISPARITY box 154 allows the user to select a positive or negative initial disparity. Clicking on a PWM (pulse width modulation) box 156 above the ENCODING region 114 activates a pulse width modulated function that allows the user to generate a pulse width modulated signal. The pulse width modulation function has a T_MINOR box 158 in which the user sets the negative state of the bit in the pulse width modulated signal in unit intervals. The SIGNAL region 116 has a DATA RATE box 160 and an IDLE STATE box 162. Clicking on the DATA RATE box 160 allows a user to set the data rate of the serial data. The data rate may be adjusted from 10 Mega bits per seconds to 20 Giga bits per second depending on signal generator type. When the STANDARD button 124 is activated, the data rate is automatically selected as a function of the selected serial data standard. The IDLE STATE box 162 is active when SATA is selected in the STANDARD box 130 and Idle Pattern is selected in the PATTERN box 132. The Idle State may be viewed as selectable periods of DC within the pattern.

The AMPLITUDE region 118 has a MAXIMUM AMPLITUDE box 164 and a MINIMUM AMPLITUDE box 166. The MAXIMUM AMPLITUDE box 164 and a MINIMUM AMPLITUDE box 166 allows the user to specify the maximum and minimum amplitude levels of the serial data pattern. The RISE/FALL region 120 has RISE/FALL TIME buttons 168 and 170 for respectively selecting 10/90 or 20/80 percent rise and fall time. A RISE box 172 allows the user to select the rise time of the serial data pattern leading edges. A FALL box 174 allows the user to set the fall time of the serial data pattern trailing edges. Clicking on the DCD box 176, activates the DCD region 178 allowing the user to vary the amount of Duty Cycle Distortion in the serial data pattern. The rise, fall and DCD times may be defined in seconds or unit intervals using the respective SETTING boxes 180.

The MARKER SETTING region 122 has a MARKER 1 section 182 and a MARKER 2 section 184. Each MARKER section 182, 184 has option buttons 186, 188 and 190. Clicking on the one of the BASE PATTERN buttons 186 sets that particular marker output to be the same as the base pattern. Clicking on one of the CLOCK buttons 188 activates a CLOCK PATTERN box 192 and a FREQUENCY box 194. The CLOCK PATTERN box 192 allows the user to select from a list of clocks or allows the user to define a clock pattern. If the user selects to define the clock pattern, then the user may set the frequency of the clock using the FREQUENCY box 194. Clicking on one of the HIGH/LOW buttons 190 activates a SELECTION box 196 to allow the user to set the marker output to ALL HIGH, ALL LOW or TRIGGER. Selecting the TRIGGER option activates SAMPLE box 198 that allows the user to set the beginning number of samples of the waveform to high.

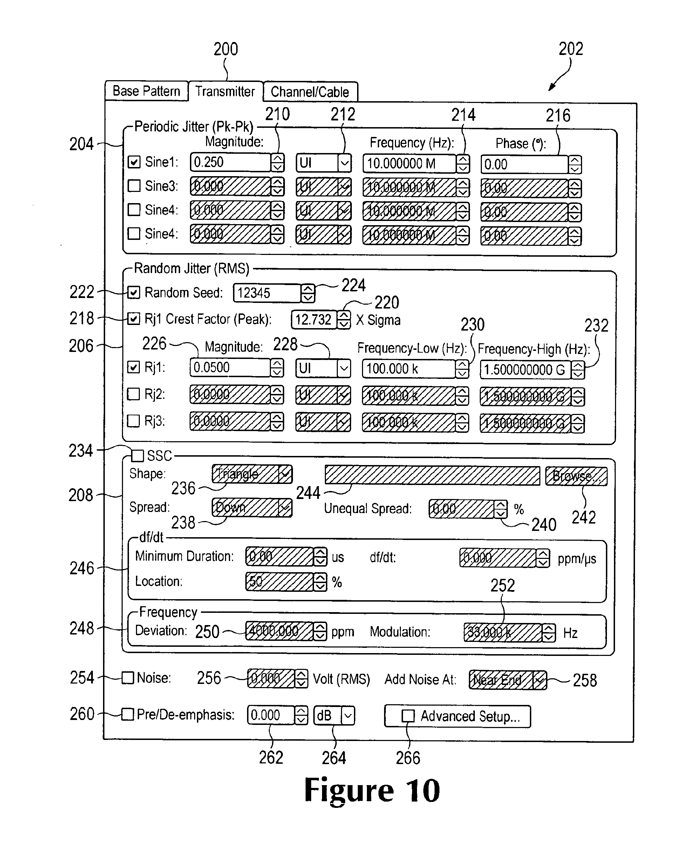

Clicking on the TRANSMITTER tab 200 activates a TRANSMITTER pop-up window 202 as shown in Figure 10. The TRANSMITTER pop-up window 202 has three defined regions: PERIODIC JITTER (PK-PK) 204, RANDOM JITTER (RMS) 206 and SSC 208. The PERIODIC JITTER (PK-PK) region 204 allow the user to set parameters for up to four sine wave impairment signals: Sine 1, Sine 2, Sine 3 and Sine 4 that may be applied to the serial data pattern. Each sine wave impairment signal has a MAGNITUDE box 210 for setting the magnitude of the sine wave impairment signal and associated SETTING box 212 for defining the magnitude in unit intervals or seconds. Each sine wave impairment signal also has a FREQUENCY box 214 and a PHASE box 216 for setting the frequency and phase for impairment signal. The RANDOM JITTER region 206 allows the user to set parameters for generating "crest factor emulation". Clicking on the RJ1 CREST FACTOR (PEAK) box 218 activates a SCALER box 220 where the user can enter a value from 1 to 20 that is multiplied by the sigma (σ) to generate a peak value in unit intervals. Clicking on the RANDOM SEED box 222 activates a RANDON SEED VALUE box 224 allowing the user to assign a maximum five digit seed value for using the same random jitter sequence for each compilation of the digital data pattern with impairments. The RANDON JITTER region allows a user to set parameters for three random jitter impairment signals: Rj1, Rj2 and Rj3 that may be applied to the signal data pattern. Each random jitter impairment signal has a MAGNITUDE box 226 for setting the magnitude of the random jitter impairment signal and associated SETTING box 228 for defining the magnitude in unit intervals or seconds. Each random jitter impairment signal also has a FREQUENCY-LOW (Hz) box 230 and a FREQUENCY-HIGH (Hz) box 232 for setting low and high frequencies of the random jitter.

Clicking on a SCC box 234 activates the SSC (spread spectrum clock) region 208 allowing the user to set parameters of a spread spectrum clock that may be applied to the serial data pattern. The user may set the shape, spread and unequal spread for the SSC signal using the SHAPE box 236, the SPREAD box 238 and the UNEQUAL SPREAD box 240. The user may also select a previously stored custom shape clicking on a BROWSE button 242 and entering the file name in a CUSTOM SHAPE box 244. The SSC region 208 includes a df/dt section 246 where the user can insert a deviation in a standard SCC profile. A FREQUENCY section 248 having a DEVIATION box 250 and a MODULATION box 252 allows the user to set frequency parameters of the SSC signal.

Below the SSC region 208 are additional parameters that may be set by the user. Clicking on a NOISE box 254 activates a NOISE VALUE box 256 allowing the user to set a noise parameter in VOLTS (RMS) for adding noise to the signal data pattern. The user has the option of placing the noise at the near end or the far end of the signal data pattern using ADD NOISE AT box 258. Clicking on a PRE/DE-EMPHASIS box 260 activates a PRE/DE-EMPHASIS parameter box 262 allowing the user to set a pre-emphasis or de-emphasis parameter for the signal data pattern. The pre-emphasis or de-emphasis parameter may be set in dB or volts using the UNITS box 264. Clicking on the ADVANCED SETUP box 266 activates another pop-up window allowing the user to set additional pre-emphasis and de-emphasis parameters.

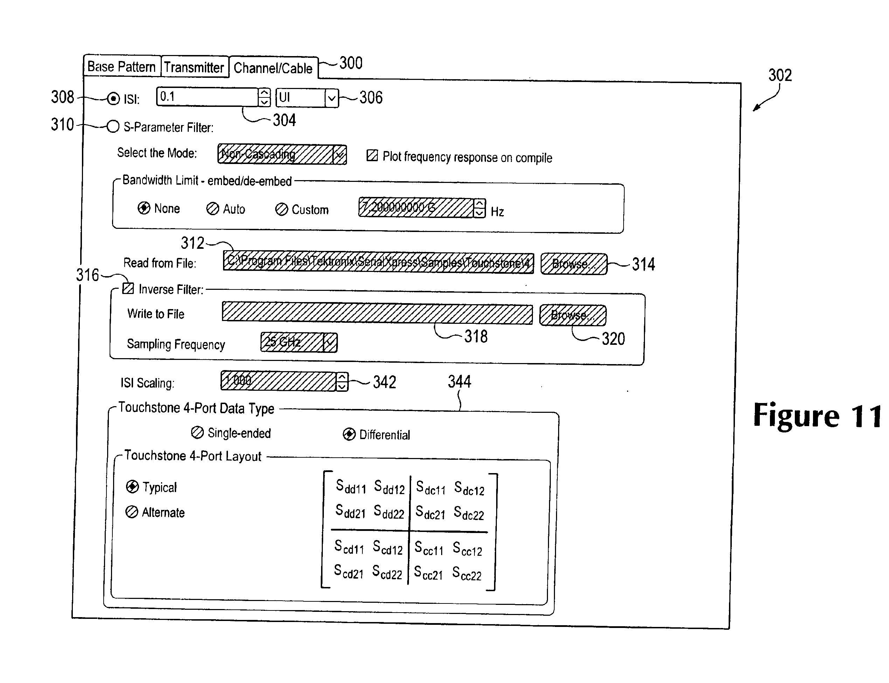

Clicking on the CHANNEL/CABLE tab 300 activates a CHANNEL/CABLE pop-window 302 as shown in Figure 11. The user may activate an ISI box 304 and SETTING box 306 by clicking on an ISI button 308. In the present invention, the user clicks on an S-PARAMETER FILTER button 310 to activate various S-Parameter Filter boxes and buttons. A READ FROM FILE box 312 and associated BROWSE button 314 allows the user to select a previously stored S-Parameter Touchstone file correspond to the backplane and cable deterministic jitter requirements for the configuration in which the receiver function. Clicking on an INVERSE FILTER button 316 activates an INVERSE FILTER box 318 and associated BROWSE button 320 to allow the user to select a previously stored S-Parameter Touchstone file. An ISI SCALING box 322 allows the user to select an ISI scaling factor value which may be varied from 0.000 to 10.000 in increments of 0.001. Below the ISI SCALING box 322 is a SELECTION region 324 that displays various selection options for various ports defined by the S-Parameter Touchstone files.

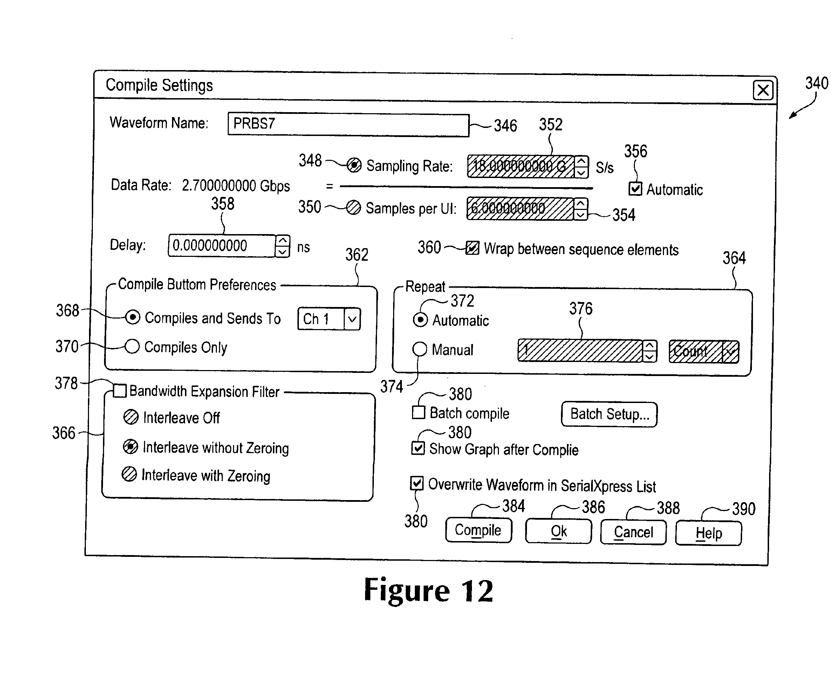

Referring back to Figure 8, once the user has set the parameters for the signal data pattern with deterministic and random jitter impairments and the signal data pattern with deterministic and random jitter impairments and the displacement crest factor emulation impairment, to be described in greater detail below, the user activates a COMPILE SETTINGS pop-up window 340, shown in Figure 12, by clicking on a COMPILE SETTINGS button 342 on the initial user interface 100 tool bar 344 in Figure 8. The COMPILE SETTINGS pop-up window 340 has a WAVEFORM NAME box 346 that allows a user to define a name for a waveform record file generated by the signal generator 50 using the user defined signal data pattern with deterministic and random jitter impairments and the signal data pattern with deterministic and random jitter impairments and the displacement crest factor emulation impairment. The data rate for the serial data pattern entered using the BASE PATTERN pop-up window 108 is displayed next to "Data Rate". The user can click on a SAMPLE RATE button 348 or a SAMPLES PER UI button 350 to activate respective SAMPLE RATE or SAMPLES PER UI boxes 352, 354. The user may manually set the sampling rate or samples per UI by entering appropriate values based on the serial data pattern and the data rate. The sampling rate or samples per UI may be automatically set based on the data rate and the serial data pattern by clicking on AUTOMATIC box 356. A DELAY box 358 is provided to help in aligning the start and stop points in waveform sequence elements. The user can set a delay of the next waveform sequence element to allow magnitude alignment of the ending and starting points of the waveform sequence elements. A WRAP BETWEEN SEQUENCE ELEMENTS box 360 may be clicked on to ensures continuity of the waveform when the sequence execution moves from one sequence element to another.

The COMPILE SETTING pop-up window 340 has a COMPILE BUTTON PREFERENCE region 362, a REPEAT region 364 and a BANDWIDTH EXPANSION FILTER region 366. Clicking on the COMPILE AND SEND TO button 368 in the COMPILE BUTTON PREFERENCE region 362 allows the user to select a channel for the compiled waveform record file based on the digital data pattern and impairment parameters. Clicking on the COMPILE ONLY button 370 save the compiled waveform record file in the user named waveform record file. The REPEAT region 364 has an AUTOMATIC button 372 that when activated automatically builds a waveform from repeating pieces based on the Pj, Rj, and SSC frequency values. A MANUAL button 374 allows the user to set the repeat count using a MANUAL COUNT box 376. The repeat count may be set in counts or seconds. Clicking on the BANDWIDTH EXPANSION FILTER box 378 activates the BANDWIDTH EXPANSION FILTER region 366. The signal generator 50 has hardware circuitry that internally provides automatic interleaving of the CH1 and CH2 digital-to-analog converter outputs for high sample rates, such as 12 GS/s and higher. The user may select to leave interleaving off, interleave without zeroing and interleaving with zeroing. On the lower right side of the COMPILE SETTINGS pop-up window 340 are additional parameters that may be set by clicking on the appropriate boxes 380. One of the parameters is SHOW GRAPH AFTER COMPILE which displays the signal data pattern with deterministic and random jitter impairments and the signal data pattern with deterministic and random jitter impairments and the displacement crest factor emulation impairment in various forms in two graph regions 382 at the bottom of the initial user interface 100. At the bottom of the COMPILE SETTINGS pop-up window 340 are COMPLE, OK, CANCEL and HELP buttons 384, 386, 388 and 390 that allows the user to select various options related to the COMPILE SETTINGS pop-up window 340. One option is to click on the COMPILE button 384 that initiates the compiling of the signal data pattern with deterministic and random jitter impairments and the signal data pattern with deterministic and random jitter impairments and the displacement crest factor emulation impairment to generate respective waveform record files. The waveform record files are processed by the waveform generation circuit 70 to generate an analog waveform test serial from the waveform record files having deterministic jitter impairments, random jitter impairments, and the displacement crest factor emulation impairment. Another option is to click on the OK button 386 that saves the parameters selected in the COMPILE SETTINGS pop-up window 340 and closes the window 340. A further option is to click on the CANCEL button 388 that closes the COMPILE SETTINGS pop-up window 340 without saving the parameters selected in the window 340. Clicking on the HELP button 390 activates a HELP pop-up window from which the user may seek help.

The initial user interface 100 tool bar 344 has a COMPILE button 392 (as shown in Figure 8) that functions in the same manner as the COMPILE button 384 (as shown in Figure 12) in the COMPILE SETTINGS pop-up window 340 by initiating the compiling of the serial data pattern with the various other parameters to generate a waveform record file containing digital data for generating an analog waveform test signal from the signal generator 50.

A specific implementation for generating a waveform test signal having crest factor emulation of random jitter will now be described using the arbitrary waveform signal generator 50 and the user interfaces previously described with reference to Figures 8 through 12. The parameters for the serial data pattern, such as pattern type, data rate, amplitude rise/fall time, sample rate samples per unit interval are input by the user. Deterministic jitter impairments and random jitter impairments are also input by the user for the defined serial data pattern. A single sine wave waveform and a single random jitter waveform are used in this implementation for generating a waveform test signal having crest factor emulation of random jitter. The Crest Factor parameter in the Rj1 Crest Factor (peak) box 220 is set to zero for this first waveform record file. The serial data pattern parameters along with the deterministic and random jitter impairments are compiled to generate a first waveform record file, x(n), that is stored in memory 62 of the signal generator 50. The compiling of the random jitter parameter is implemented as a pseudo random Gaussian noise generator.

A second waveform record file is generated with the same serial data pattern parameters and deterministic and random jitter parameters. The RJ1 CREST FACTOR (PEAK) box 218 is activated and a scalar value is entered into the SCALAR box 220 that is multiplied by sigma (σ) to produce a low probability, large amplitude jitter sigma (σ) value for this second waveform record file. As with the first waveform record file, the parameters of the serial data pattern and the parameters of the periodic and random noise parameters are compiled to generate the waveform record file, y(n) (Rj with CF), that is also stored in memory 62. The waveform record files x(n) and y(n) (Rj with CF) have the same jitter statistics except a single sample at index "k" is changed to meet the required Crest Factor CF. "k" is chosen based on the exact time when Rj is required to attain its peak value. This value can be precisely synchronized with the peak deterministic jitter.

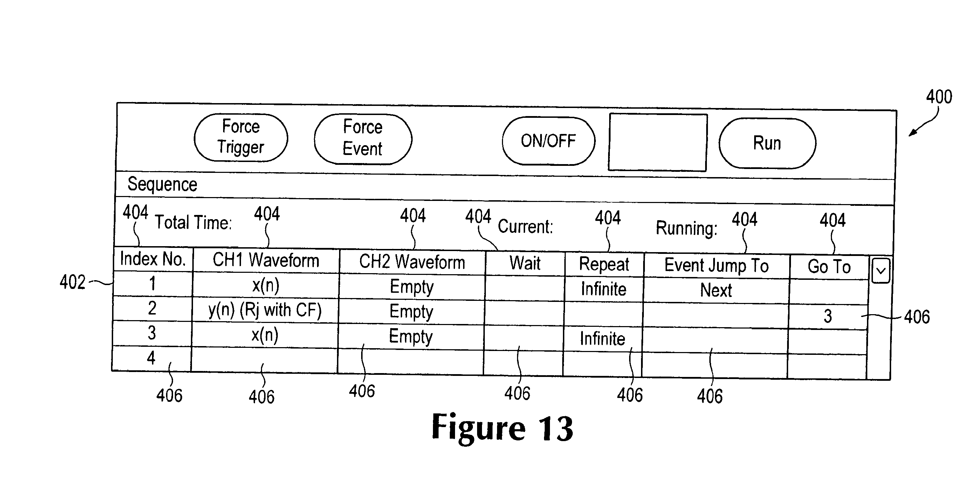

Where a compliance test waveform is very long and has repeating sequences each of the stored waveform record files may contain a single sequence of the compliance test waveform. Referring to Figure 13, there is shown a SEQUENCER user interface 400 of the signal generator 50 for setting sequences of stored waveform record files. The SEQUENCER user interface 400 has rows 402 and columns 404 defining a matrix of cells 406. The rows 402 define sequences with the INDEX NO cells of the first column defining the index number. The CH 1 WAVEFORMS column defines cells where the user can assigns a stored waveform record file to a sequence. Where the signal generator has first and second output files, a CH 2 WAVEFORMS column defines cells where the user can assigns a stored waveform record file to a sequence. The WAIT column defines cells where a "wait" state causes the waveform record of that sequence to wait until a trigger signal is received before initiating the output of the waveform record. The REPEAT column defines cells having a repeat number "N" for the particular waveform record in the sequence. The repeat number "N" in the cell causes the particular waveform record to repeat the prescribed number of "N" time. The EVENT JUMP TO column defines cells having a sequence number "M" which sequencer accesses in response to an external event. Each cell may have a particular sequence number "M" or the term "next" which will initiate the next sequence number after the current sequence number. The GO TO column define cells with a sequence number "M" that causes the sequencer to access the sequence defined by the sequence number "M" after the completion of the current sequence. The GO TO sequence number "M" may be the next sequence number in the sequencer or may cause the sequencer to jump to a sequence number that is out of sequence with next sequence number.

The first waveform record file, x(n), is assigned to sequence 1 in the sequencer 400 by loading the file name x(n) of the waveform record into the CH 1 WAVEFORM cell of sequence 1. The waveform record file is set to repeat and infinite number of time by loading sequence 1 REPEAT cell with the term "infinite". The EVENT JUMP TO cell is loaded with the term "next" which will cause the sequencer to jump to the next sequence number after an external event, such as a user activating a FORCE EVENT button on the front panel 52 of the signal generator 50. The second waveform record file, y(n) (Rj with CF), is assigned to sequence 2 of the sequencer. The REPEAT COUNT cell of sequence 2 is set to 1 so the second waveform will output only once. The GO TO cell in sequence 2 is set to 3 which will cause the sequencer to jump to sequence 3 of the sequencer 400. The CH1 WAVEFORM cell of sequence 3 is loaded with file name x(n) of waveform record file x(n). The REPEAT cell of sequence 3 is loaded with the term "infinite" which cause waveform record file x(n) too continuously repeat. The waveform record files x(n) and y(n) (Rj with CF) are provided to the waveform generation circuit 30 which converts the digital waveform record file to an analog output waveform test signal based on user defined parameters.

An alternate way that provides similar results would be to load the REPEAT cell of sequence 1 with a number "N" that causes the sequencer 400 to repeat waveform record x(n) "N" number of time. The EVENT JUMP TO cell of sequence 1 is left empty and the GO TO cell of sequence 1 is loaded with a number 2 representing sequence 2. This will cause the sequencer 400 to jump to sequence 2 when sequence 1 is repeated "N" times. The REPEAT cell for the sequence 2 is loaded with the number 1 which cases the sequencer 400 to output the waveform of waveform record file y(n) (Rj with CF) once. The GO TO cell of sequence 2 is loaded with a number 3 representing sequence 3. This causes the sequencer 400 to jump to the sequence 3. The REPEAT cell of sequence 3 does not change and the waveform record file x(n) is set to repeat and infinite number of times.

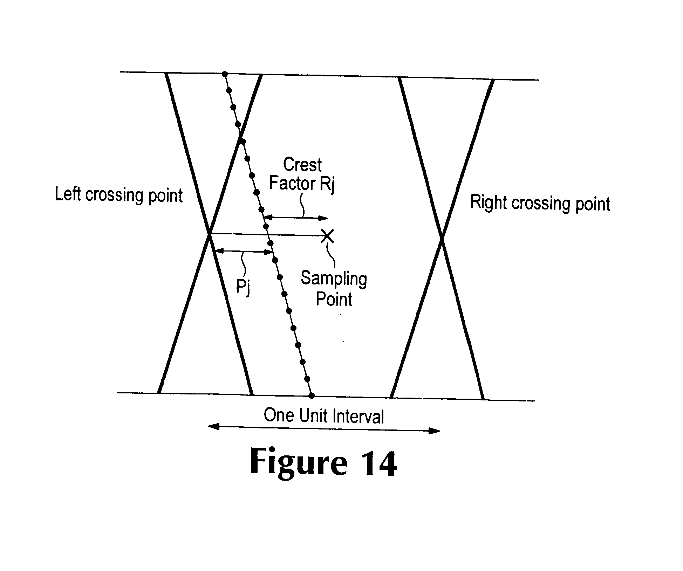

Figure 14 illustrates the random jitter with a forced Crest Factor CF in relation to a unit interval UI. A sampling point is shown in the center of the unit interval (UI). The total jitter which can produce an error is equal to half of a UI. Hence, when the peak periodic jitter Pj and the Crest Fact of the random jitter Rj occur at the same instant, the total jitter will be 0.5 UI, which results in an error. The waveform record file y(n) (Rj with CF) in sequence 2 of the sequencer 400 has the random jitter with the required Crest Factor. A bit error will occur when the sequencer 400 jumps to the sequence 2. In the waveform record file y(n) (Rj with CF), both the peak of the deterministic sine jitter and the peak of the random jitter (Crest Factor value) will occur at the same time. In the illustration of Figure 14, the peak sine jitter is 0.3 UI and the forced Crest Factor value is 0.2 UI. The total jitter will be 0.5 UI. This will cause a bit error.

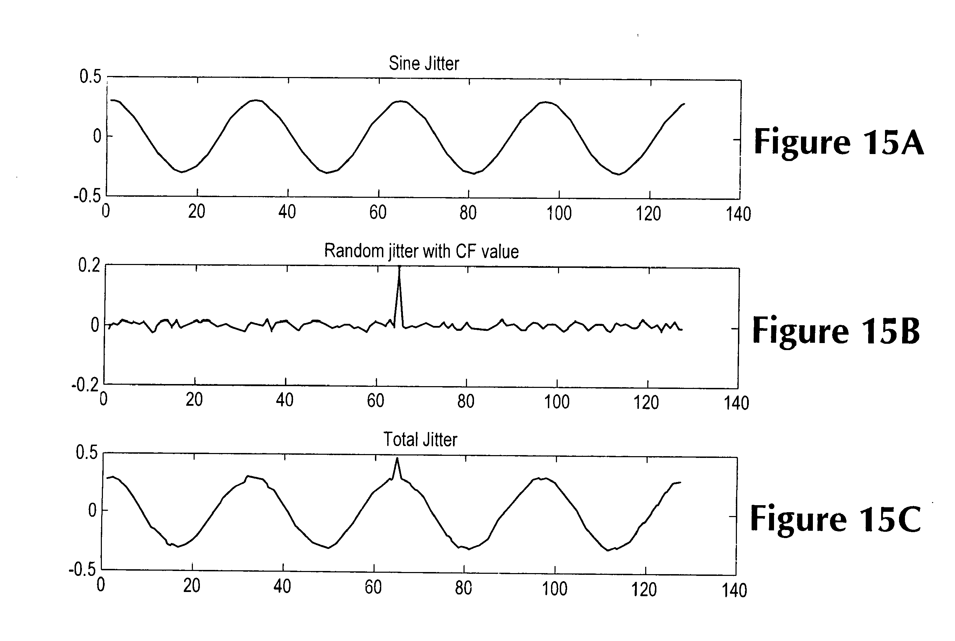

Figures 15A through 15C illustrate the peaks of the deterministic sine jitter and the random jitter (Crest Factor value) occurring at the same time. Figure 15A illustrates the sine jitter applied to the serial data pattern. Figure 15B illustrates the random jitter with a Crest Factor value applied to the serial data pattern. Figure 15C illustrates the total jitter being applied to the serial data pattern being the combination of the sine jitter and the random jitter with a Crest Factor value. The peak Crest Factor value of the random jitter Rj coincides with a peak in the sine jitter Sj (deterministic jitter Pj). Figures 15A through 15C illustrate one example of applying the low probability, large amplitude jitter sigma (σ) value of the random jitter to sine jitter. The low probability, large amplitude jitter sigma (σ) value of the random jitter need not be a positive direction as shown Figures 15A through 15C but may also be in a negative direction. While it is preferred that the low probability, large amplitude jitter sigma (σ) value of the random jitter coincide with the peak of the sine jitter, the low probability, large amplitude jitter sigma (σ) value of the random jitter may be positioned at any location of the sine jitter.

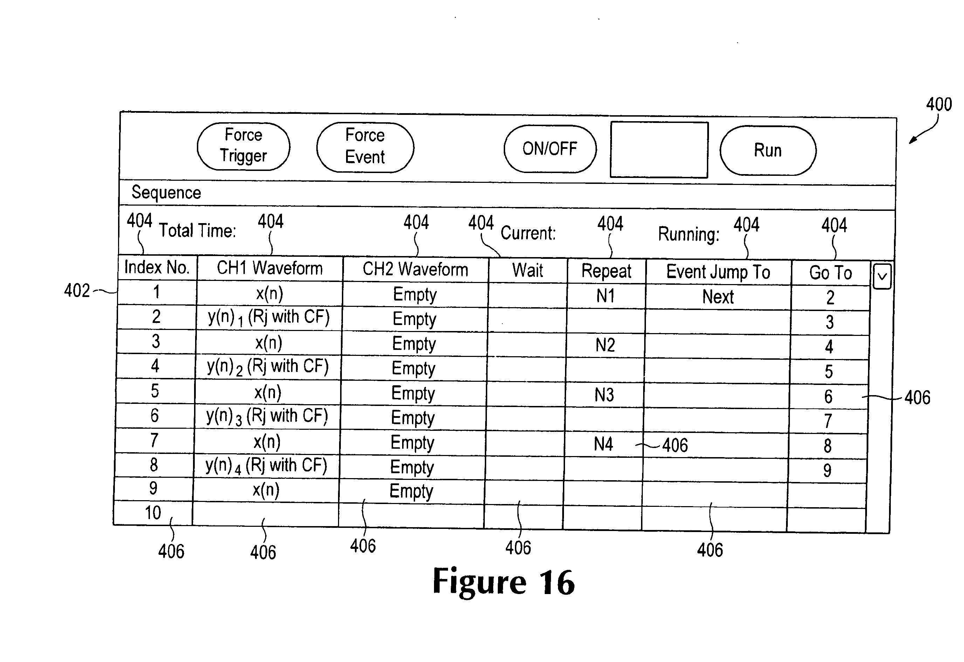

A further embodiment for generating a waveform test signal having crest factor emulation of random jitter uses multiple low probability, large amplitude jitter sigma (σ) values of the random jitter. This embodiment simulates a compliant stressed receiver tolerance test using a hardware random noise source. Referring to Figure 16, there is shown the SEQUENCER user interface 400 having multiple y(n) (Rj with CF) waveform records. Each waveform record y(n)₁ to y(n)ₙ (Rj with CF) has a different and increasing low probability, large amplitude jitter sigma (σ) values of the random jitter. For example, the scalar value entered into the SCALAR box 220 for waveform record y(n)₁ may be set to 5. The scalar value entered into the SCALAR box 220 for waveform record y(n)₂ may be set to 6. The scalar value entered into the SCALAR box 220 for waveform record y(n)₃ may be set to 7. The scalar value entered into the SCALAR box 220 for waveform record y(n)₄ may be set to 8 and so on.

The SEQUENCER user interface 400 is configured with the first waveform record file, x(n), assigned to sequence 1 by assigning the x(n) waveform record file into the CH 1 WAVEFORM cell of sequence 1. The waveform record file is set to repeat a defined number of times by loading sequence 1 REPEAT cell with an integer value, N1. The EVENT JUMP TO cell is left empty and the GO TO cell set to sequence 2. The CH1 WAVEFORM cell of sequence 2 is assigned the y(n)₁ (Rj with CF) waveform record file. The REPEAT COUNT cell of sequence 2 is set to 1 so the y(n)₁ (Rj with CF) waveform record file will output only once. The GO TO cell in sequence 2 is set to 3 which will cause the sequencer to jump to sequence 3 of the sequencer 400. The CH1 WAVEFORM cell of sequence 3 is assigned the x(n) waveform record file. The REPEAT cell of sequence 3 is loaded with another integer value, N2, which cause waveform record file x(n) too repeat a selected number of times. The GO TO cell in sequence 3 is set to 4 which will cause the sequencer to jump to sequence 4. The CH1 WAVEFORM cell of sequence 4 is assigned the y(n)₂ (Rj with CF) waveform record file. The REPEAT COUNT cell of sequence 4 is set to 1 so the y(n)₂ (Rj with CF) waveform record file will output only once. The GO TO cell in sequence 4 is set to 5 which will cause the sequencer to jump to sequence 5 of the sequencer 400. The CH1 WAVEFORM cell of sequence 5 is assigned the x(n) of waveform record file. The REPEAT cell of sequence 5 is loaded with another integer value, N3, which cause waveform record file x(n) too repeat a selected number of times. The GO TO cell in sequence 5 is set to 6 which will cause the sequencer to jump to sequence 6. The CH1 WAVEFORM cell of sequence 6 is assigned the y(n)₃ (Rj with CF) waveform record file. The REPEAT COUNT cell of sequence 6 is set to 1 so the y(n)₃ (Rj with CF) waveform record file will output only once. The GO TO cell in sequence 6 is set to 7 which will cause the sequencer to jump to sequence 7 of the sequencer 400. The CH1 WAVEFORM cell of sequence 7 is assigned the x(n) of waveform record file. The REPEAT cell of sequence 7 is loaded with another integer value, N4, which cause waveform record file x(n) too repeat a selected number of times. The GO TO cell in sequence 7 is set to 8 which will cause the sequencer to jump to sequence 8. The CH1 WAVEFORM cell of sequence 8 is assigned the y(n)₄ (Rj with CF) waveform record file. The REPEAT COUNT cell of sequence 8 is set to 1 so the y(n)₄ (Rj with CF) waveform record file will output only once. The GO TO cell in sequence 8 is set to 9 which will cause the sequencer to jump to sequence 9 of the sequencer 400. The CH1 WAVEFORM cell of sequence 9 is assigned the x(n) of waveform record file. The REPEAT cell of sequence 9 is loaded with the term "infinite" which causes the x(n) waveform record to repeat infinite times.

The integer values N1, N2, N3, N4 and so one represent repeat values that, in this embodiment, increase with increasing Index Numbers thus increasing the delay time between instances of the low probability, large amplitude jitter sigma (σ) values of the random jitter. For example, N1 may be set to repeat 1000 times, while N2 may be set to repeat 100,000 times. N3 may be set to repeat 10,000,000 time and N4 may be set to repeat 100,000,000 times. The number of times the x(n) waveform record is repeated is based on the time required for the x(n) waveform record file to be converted the analog waveform test signal and desired delay time between the instances of the low probability, large amplitude jitter sigma (σ) values of the random jitter. While this embodiment takes significantly longer than applying a single instance of a low probability, large amplitude jitter sigma (σ) value of the random jitter to a waveform test signal, this embodiment does provide for low probabilities, and repeatability which allows for controlling and verifying the tolerance testing.

It will be obvious to those having skill in the art that many changes may be made to the details of the above-described embodiments of this invention without departing from the underlying principles thereof. The scope of the present invention should, therefore, be determined only by the following claims.

## Claims

1. A signal generating device comprising:
a display;
a central processing unit generating a user interface on the display for setting parameters for a serial data pattern and parameters for deterministic jitter impairments, random jitter impairments, and at least one displacement crest factor emulation impairment to be applied to the serial data pattern, wherein a waveform record file is generated using the serial data pattern parameters, and the serial data pattern impairment parameters for the deterministic jitter, random jitter, and the displacement crest factor emulation impairment with the displacement crest factor emulation impairment being selectively positioned in the impaired serial data pattern; and
a waveform generation circuit receiving the waveform record file and generating an impaired serial data pattern analog output signal based on the serial data pattern parameters and the parameters for deterministic jitter impairments, random jitter impairments, and at least one displacement crest factor emulation impairment with the displacement crest factor emulation impairment being selectively positioned in the impaired serial data pattern analog output signal.

2. The signal generating device as recited in claim 1 wherein the serial data pattern corresponds to a serial data standard having templates wherein frequencies of the sinusoidal jitter impairments correspond to the frequencies of serial data pattern template.

3. The signal generating device as recited in claim 1 wherein the random jitter impairments further comprise pseudorandom jitter impairments that are applied to every transition of the serial data pattern except for a transition having median deterministic jitter impairments.

4. The signal generating device as recited in claim 3 wherein the transition having median deterministic jitter impairments has a median level intersymbol interference and one-half sinusoidal amplitude.

5. The signal generating device as recited in claim 1 wherein the parameter for the displacement crest factor emulation impairment comprises a low probability, large amplitude jitter sigma (σ) value greater than four sigma (σ) of the random jitter impairment.

6. The signal generating device as recited in claim 1 wherein the parameter for displacement crest factor emulation impairment further comprises a plurality of parameters for displacement crest factor emulation impairments with each parameter for displacement crest factor emulation impairment having a selectable low probability, large amplitude jitter sigma (σ) value, each of the displacement crest factor emulation impairment parameters of the plurality of displacement crest factor emulation impairment parameters being selectively positioned in the impaired serial data pattern with increasing selectable low probability, large amplitude jitter sigma (σ) values for each of the plurality of displacement crest factor emulation impairment parameters being positioned at increasingly longer durations of the impaired serial data pattern.

7. A method of generating a waveform test signal having crest factor emulation of random jitter comprising the steps of:
generating a serial data pattern;
applying deterministic jitter impairments to the serial data pattern;
applying random jitter impairments to selected portions of the waveform test signal;
applying at least one displacement crest factor emulation impairment at a location in the serial data pattern where the random jitter impairments are absent;
generating a waveform test signal from the serial data pattern having deterministic jitter impairments, random jitter impairments, and the displacement crest factor emulation impairment.

8. The method of generating a waveform test signal having crest factor emulation of random jitter as recited in claim 7 wherein the applying deterministic jitter impairments step further comprises the step of generating deterministic jitter impairments selected from a group of parameters for intersymbol interference impairments, duty cycle distortion impairments, sinusoidal jitter impairments, spread spectrum clock impairments, and crosstalk impairments.

9. The method of generating a waveform test signal having crest factor emulation of random jitter as recited in claim 7 wherein the applying deterministic jitter impairments step further comprises the steps of:
generating sinusoidal jitter impairments; and
setting sinusoidal jitter amplitude and frequency values as a function of a serial communication system standard template.

10. The method of generating a waveform test signal having crest factor emulation of random jitter as recited in claim 7 wherein the applying random jitter impairments step further comprises the step of generating pseudorandom jitter impairments.

11. The method of generating a waveform test signal having crest factor emulation of random jitter as recited in claim 7 wherein the applying at least one displacement crest factor emulation impairment step further comprises the step of generating at least one displacement crest factor emulation impairment at a transition location in the digital data pattern having a median level intersymbol interference and one-half sinusoidal amplitude.

12. The method of generating a waveform test signal having crest factor emulation of random jitter as recited in claim 7 wherein the displacement crest factor emulation impairment has a large amplitude, low probability jitter value having a value of greater than 4σ of the random jitter impairment distribution.

13. The method of generating a waveform test signal having crest factor emulation of random jitter as recited in claim 7 wherein the applying at least one displacement crest factor emulation impairment step further comprises the step of applying a plurality of displacement crest factor emulation impairments with each displacement crest factor emulation impairment having a selectable low probability, large amplitude jitter sigma (σ) value.

14. The method of generating a waveform test signal having crest factor emulation of random jitter as recited in claim 13 wherein the applying the plurality of displacement crest factor emulation impairments further comprises the step of increasing the low probability, large amplitude sigma (σ) jitter values for each of the plurality of displacement crest factor emulation impairments and positioning each of the increasing low probability, large amplitude sigma (σ) jitter values of the plurality of displacement crest factor emulation impairments at increasingly longer durations of the impaired serial data pattern.

15. The method of generating a waveform test signal having crest factor emulation of random jitter as recited in claim 7 wherein the generating the waveform test signal further comprises the step of generating a waveform record file having the serial data pattern representing the waveform test signal with deterministic jitter impairments, random jitter impairments, and the displacement crest factor emulation impairment.
